# EUROPÄISCHE PATENTSCHRIFT

(11) **EP 1 902 156 B1**
(45) Veröffentlichungstag und Bekanntmachung des Hinweises auf die Patenterteilung: **27.05.2009**
(21) Anmeldenummer: 06762073.2
(22) Anmeldetag: 19.06.2006
(51) Int. Cl.: C23C 16/50, C23C 16/54

(54) **VERFAHREN ZUR KONTINUIERLICHEN ATMOSPHÄRENDRUCK PLASMABEHANDLUNG UND/ODER BESCHICHTUNG VON WERKSTÜCKEN**
METHOD FOR TREATING PLASMA AND/OR COVERING PLASMA OF WORKPIECES UNDER CONTINUOUS ATMOSPHERIC PRESSURE
PROCEDE DE TRAITEMENT PLASMA ET/OU DE REVETEMENT PLASMA EN PRESSION ATMOSPHERIQUE CONTINUE DE PIECES D'USINAGE

(30) Priorität: 24.06.2005 DE 102005029360
(43) Veröffentlichungstag der Anmeldung: 26.03.2008
(73) Patentinhaber: Softal electronic Erik Blumenfeld GmbH & Co. KG, 21107 Hamburg (DE)
(72) Erfinder: PRINZ, Eckhard, 22929 Hamfelde (DE); PALM, Peter, 22549 Hamburg (DE); FÖRSTER, Frank, 22297 Hamburg (DE)
(74) Vertreter: Raffay & Fleck
(86) Internationale Anmeldenummer: PCT/EP2006/005838
(87) Internationale Veröffentlichungsnummer: WO 2007/000255

(56) Entgegenhaltungen:
- DE-A1- 10 300 439
- US-A- 4 863 756

## Beschreibung

Die Erfindung betrifft ein Verfahren zur kontinuierlichen Atmosphärendruck Plasmabehandlung von Werkstücken, insbesondere Materialplatten oder -bahnen, gemäß Anspruch 1. Unter einer Plasmabehandlung im Sinne der Erfindung ist insbesondere auch eine Plasmabeschichtung zu verstehen.

In der Veredelungsindustrie oder bei der Herstellung von Kunststofffilmen werden diese durch eine Atmosphärendruck Plasmabehandlung, auch Koronabehandlung genannt, an der Oberfläche aktiviert. Üblicherweise besteht eine industrielle Koronaanlage aus einer Hochspannungselektrode und einer Gegenelektrode, die als Walze ausgeführt ist und über die der eng anliegende Kunststofffilm geführt wird. Die Elektrode ist parallel zur Walze angeordnet, wobei die Elektrode an eine Hochspannung von ca. 10 Kilovolt bei ca. 20-40 Kilohertz angeschlossen und die Walze mit dem Erdpotential verbunden ist. In dem wenige Millimeter betragenden Luftspalt zwischen Hochspannungselektrode und Walze mit Kunststofffilm kommt es durch die Potentialdifferenz zur Ausbildung einer Koronaentladung mit praxisüblichen Leistungen von 1 bis 5 Kilowatt pro Meter. Der Kunststofffilm wird durch die Koronaentladung aktiviert, d.h. an der Oberfläche oxidiert.

Durch die Aktivierung wird die Oberflächenspannung erhöht, um so ausreichende Haftung zu Druckfarben und Klebern zu gewährleisten.

Für höhere Haftungsanforderungen ist nach der Plasmaaktivierung der Auftrag eines Primers auf den Kunststofffilm erforderlich. Primer bestehen im Allgemeinen aus einer die Haftung verbessernden Komponente und zum überwiegenden Teil aus Lösungsmittel. Nach dem Primerauftrag, z.B. durch Walzen, muss das Lösungsmittel entfernt werden, was durch einen Trockentunnel erfolgt und sofern es sich um ein organisches Lösungsmittel handelt, muss dieses thermisch verbrannt werden.

Somit ist dieser Prozess hinsichtlich der erforderlichen Komponenten - Auftragswerk, Trocknung und Nachverbrennung - mit hohen Kosten hinsichtlich der Investition und des laufenden Betriebs verbunden.

Daher wird bereits seit vielen Jahren versucht, den nasschemischen Primerauftrag durch einen Atmosphäredruck Plasmabeschichtungsprozess zu ersetzen, der ohne Lösungsmittel auskommt. Dabei entfällt die Trocknung und die Nachverbrennung. Das Auftragswerk ist durch eine Atmosphärendruck Plasmabeschichtungseinheit zu ersetzen.

Dazu wird in die Atmosphärendruck Plasmaentladung Trägergas z.B. Luft, Stickstoff, Edelgas oder deren Gemische mit Precusoren z.B. Tetramethylorthosilikat, Hexamethylendisiloxan in das Elektrodensystem eingespeist, um das auf der geerdeter Gegenelektrode aufliegende Substrat zu beschichten.

Dabei wird neben dem Substrat auch das Elektrodensystem selbst beschichtet. Dadurch wird der erforderliche Entladespalt zwischen Elektrodensystem und Gegenelektrode geschlossen und der Beschichtungsprozess muss zur Reinigung unterbrochen werden, was für kontinuierliche industrielle Prozesse nicht akzeptabel ist.

Das Dokument DE10300439 offenbart ein Verfahren zur kontinuierlichen Plasmabehandlung unter Atmosphärendruck von elektrisch isolierenden Werkstücken. Ein zu behandelndes Werkstück ist in einem Abstand einer sich quer zu der Bewegungsrichtung über die Breite der zu behandelnden Oberfläche des Werkstückes erstreckenden Hochspannungselektrode angeordnet. Die Elektrode und das Werkstück sind relativ zueinander in Bewegung versetzt. Eine Plasmaentladung wird in der (zweiten) Atmosphäre auf der Hochspannungselektrode abgewandten Seite des Werkstückes gezündet.

Vor diesem Hintergrund soll mit der Erfindung ein Verfahren angegeben werden, mit welchem ein Werkstück auf einer den Elektroden abgewandten Seite einer Atmosphärendruck Plasmabehandlung und/oder -entladung unterzogen werden kann.

Diese Aufgabe wird gelöst durch ein Verfahren zur kontinuierlichen Atmosphärendruckplasmabehandlung und/oder Plasmabeschichtung mit den Merkmalen des Anspruches 1.

Der wesentliche Aspekt des erfindungsgemäßen Verfahrens besteht darin, jeweils unterschiedliche Atmosphären auf der der mindestens einen Hochspannungselektrode zugewandten Seite des Werkstückes und der der Elektrode abgewandten Seite des Werkstückes zu schaffen. Durch eine geeignete Einstellung der beiden Atmosphären und der Hochspannung kann erreicht werden, dass in jedem Fall eine Plasmaentladung in der zweiten Atmosphäre, also der Atmosphäre auf der der Hochspannungselektrode abgewandten Seite des Werkstückes zündet. Hierdurch kann gezielt eine Rückseitenbehandlung bzw. -beschichtung des Werkstückes erfolgen.

Insbesondere im Fall einer Plasmabeschichtung kann so vermieden werden, dass die mindestens eine Hochspannungselektrode selbst beschichtet wird und entsprechend in Abständen gereinigt bzw. gewartet werden muss.

Die Einstellung der unterschiedlichen Atmosphären kann beispielsweise durch das Einbringen unterschiedlicher Gase oder Gasgemische vorgenommen werden (vgl. Anspruch 2) oder aber auch durch das Einstellen unterschiedlicher Drücke (vgl. Anspruch 3). In diesem Zusammenhang ist anzumerken, dass unter "Atmosphärendruck" im Sinne dieser Erfindung auch noch solche Drücke verstanden werden sollen, die gegenüber dem Normaldruck von 1.013 Millibar etwas erhöht bzw. erniedrigt sind. Hierbei werden Druckdifferenzen von etwa + 100 Millibar um diesen Normaldruck noch unter "Atmosphärendruck" fallend angesehen.

In der Praxis wird sicherlich häufiger die in Anspruch 2 genannte Variante der Einstellung unterschiedlicher Atmosphären, also die Einstellung mittels unterschiedlicher Gase bzw. Gasgemische gewählt werden. Zum Beispiel kann, wenn nur auf der Rückseite (also in der zweiten Atmosphäre) eine Plasmaentladung gewünscht wird, dort ein Gas oder Gasgemisch eingesetzt werden, welches höhere freie Weglängen erlaubt und somit eine Plasmazündung bei einer geringeren Hochspannung als in der ersten Atmosphäre. Unter einem unterschiedlichen Gasgemisch im Sinne dieser Erfindung sind auch solche unterschiedlichen Gase oder Gasgemische zu verstehen, bei welchem eines der Gasgemische einen Precursor enthält, das zweite, ansonsten gleich aufgebaute Gasgemisch nicht. Mit einer solchen Einstellung ist es z.B. möglich, durch das Einbringen von Precursoren nur in der zweiten Atmosphäre auf der Rückseite des Werkstückes eine Beschichtung, auf der Vorderseite (der der Hochspannungselektrode zugewandten Seite) lediglich eine Plasmabehandlung zu vollziehen.

In einer Variante ist es, wie oben bereits angedeutet, möglich, eine Plasmaentladung für eine Plasmabehandlung und/oder eine Plasmabeschichtung ausschließlich in der zweiten Atmosphäre zünden zu lassen, in dem die erste und die zweite Atmosphäre und die Hochspannung an der wenigstens einen Hochspannungselektrode entsprechend gewählt werden (vgl. Anspruch 4). Alternativ kann, wie bereits oben ausgeführt, eine Plasmaentladung auch in beiden Atmosphären ausgelöst werden, in dem die Einstellung der Atmosphären und der an die wenigstens eine Hochspannungselektrode angelegten Hochspannung entsprechend vorgenommen wird.

Vorzugsweise wird (vgl. Anspruch 5) die Plasmabeschichtung des Werkstückes nur auf der Rückseite, also der Seite, auf welcher die zweite Atmosphäre liegt, vorgenommen, indem dort - und nur dort - chemische Reagenzien (Precursoren) als Ausgangsmaterialien für eine Beschichtung eingebracht werden.

In der Regel werden zur Erzeugung der Plasmaentladung bzw. Koronaentladung mindestens zwei Hochspannungselektroden verwendet, die auf ein und derselben Seite des Werkstückes (in der ersten Atmosphäre) angeordnet sind (vgl. Anspruch 6).

Als für die Durchführung des Verfahrens verwendete Hochspannungselektroden kommen sowohl Barrierenelektroden (vgl. Anspruch 7) als auch Metallelektroden (vgl. Anspruch 8) als auch Kombinationen aus solchen Elektroden (z.B. eine Barrierenelektrode und eine Metallelektrode) in Frage.

Weitere Vorteile und Merkmale der Erfindung ergeben sich aus der nachfolgenden Beschreibung der Erfindung anhand von in den Figuren dargestellten Ausführungsbeispielen. In den Figuren zeigen:
- Fig. 1: eine in einer Förderrichtung eines kontinuierlich zu behandelnden bzw. mittels eines Precursors zu beschichtenden Werkstücks genommene, schematische Schnittansicht einer Vorrichtung zur Durchführung des erfindungsgemäßen Verfahrens in einer ersten Variante mit zwei Barrierenelektroden als Hochspannungselektroden und einer Plasmaentladung auf der den Barrierenelektroden abgewandten Seite des Werkstücks;
- Fig. 2: in einer ähnlichen Ansicht wie in Fig. 1 eine alternative Vorrichtung mit Metallelektroden anstelle der Barrierenelektroden;
- Fig. 3: in einer ähnlichen Ansicht wie in Fig. 1 eine weitere alternative Vorrichtung mit einer kombinierten Elektrodenanordnung aus einer Metall- und einer Barrierenelektrode;
- Fig. 4: in einer ähnlichen Ansicht wie in Fig. 1 eine weitere alternative Vorrichtung mit einer kombinierten Elektrodenanordnung mit einer Metallelektrode zwischen zwei Barrierenelektroden;
- Fig. 5: in einer ähnlichen Ansicht wie in Fig. 1 eine weitere alternative Vorrichtung mit einer kombinierten Elektrodenanordnung mit einer zwischen zwei Metallelektroden angeordneten Barrierenelektrode;
- Fig. 6: die Darstellung einer Vorrichtung wie in Fig. 1, wobei hier durch die Steuerung des Verfahrens eine Plasmaentladung auf beiden Seiten des Werkstücks auftritt;
- Fig. 7: die Darstellung einer Vorrichtung wie in Fig. 3, wobei hier durch die Steuerung des Verfahrens eine Plasmaentladung auf beiden Seiten des Werkstücks auftritt;
- Fig. 8: die Darstellung einer Vorrichtung wie in Fig. 4, wobei hier durch die Steuerung des Verfahrens eine Plasmaentladung auf beiden Seiten des Werkstücks auftritt; und
- Fig. 9: die Darstellung einer Vorrichtung wie in Fig. 5, wobei hier durch die Steuerung des Verfahrens eine Plasmaentladung auf beiden Seiten des Werkstücks auftritt.

In den Figuren sind gleiche bzw. gleichartige Elemente mit gleichen Bezugsziffern versehen.

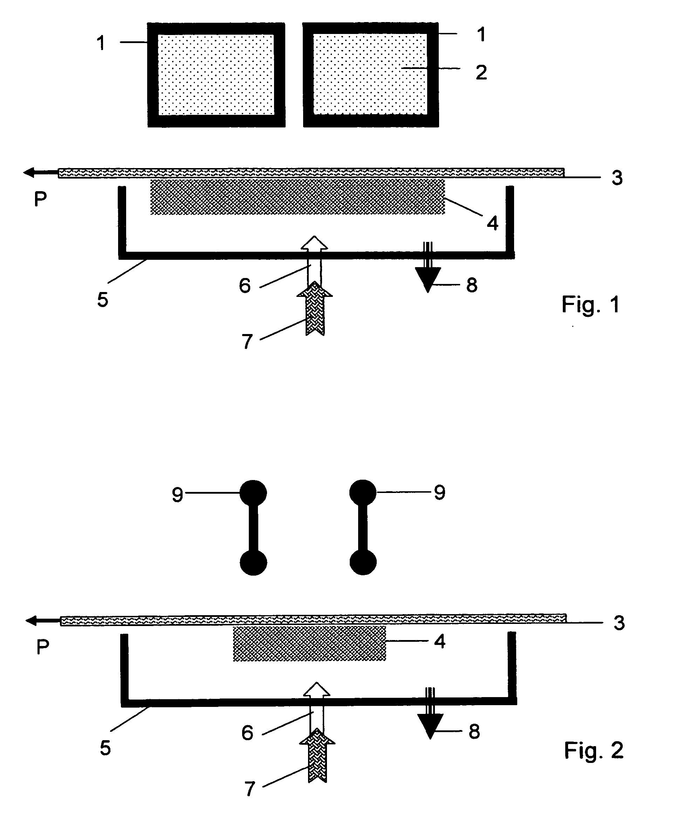

In Fig. 1 ist schematisch eine Vorrichtung zur Durchführung eines erfindungsgemäßen Verfahrens dargestellt, wie sie ein solches Verfahren in einer ersten Variante ausführt. Die Vorrichtung enthält zwei in einem Abstand zur Oberfläche eines Werkstückes 3 angeordnete Barrierenelektroden 1, an welche eine Hochspannung vorzugsweise in Form einer Wechselspannung angelegt ist. Die Barrierenelektroden 1 enthalten in ihrem Inneren einen elektrischen Leiter, der gegenüber der Umgebung mit einem Barrierenmaterial elektrisch isoliert ist. Dieses Material ist bevorzugt eine Aluminiumoxidkeramik, welche sich in diesen Anmeldungen als besonders beständig erwiesen hat. Der Raum zwischen dem Paar aus Barrierenelektroden 1 und der Oberfläche des Werkstückes 3 (in diesem Fall eine Werkstückbahn) ist mit einer ersten Atmosphäre befüllt. Auf der den Barrierenelektroden 1 abgewandten "Rückseite" des Werkstückes 3 ist ein Gehäuse 5 angeordnet, innerhalb welchem ein zweiter Raum mit einer zweiten Atmosphäre gebildet ist. Dieser Raum wird, wie mit den beiden Pfeilen angedeutet, mit einem Prozessgas 7 und optional mit einem Precursor 6 beschickt. Auf diese Art und Weise wird in dem Raum in dem Gehäuse 5 eine andere Atmosphäre eingestellt, als in dem Bereich zwischen den Barrierenelektroden 1 und dem Werkstück 3. Durch diese unterschiedlichen Atmosphären kann bei Wahl einer geeigneten Hochspannung gezielt eine Plasmaentladung 4 auf der "Rückseite" des Werkstückes 3 gezündet werden, welche als reine Plasmaentladung in einem Prozessgas eine Plasmabehandlung, bei Zusatz von Precursoren 6 eine Plasmabeschichtung auf dieser Seite des Werkstückes 3 hervorruft. Das Werkstück 3 wird, wie dies mit dem Pfeil P angedeutet ist, der die Bewegungsrichtung angibt, in dieser Richtung kontinuierlich durch die schematisch dargestellte Vorrichtung geführt und auf diese Weise in seiner Gesamtheit auf der "Rückseite" plasmabehandelt bzw. plasmabeschichtet. Mit 8 ist eine Absaugung angedeutet, d.h. hier wird das Prozessgas 7 mit eventuell verbliebenen Precursoren 6 und in der Plasmaentladung 4 generierten Spezies abgesaugt und einer hier nicht gezeigten, nachgeschalteten Abgasbehandlung zugeführt, um unerwünschte Plasmaprodukte, wie insbesondere Ozon, nicht in die Umgebung gelangen zu lassen. Es sei an dieser Stelle noch einmal hervorgehoben, dass die in der Figur schematisch mit 6 bezeichneten Precursoren für die Durchführung des Verfahrens nicht zwingend in das Gehäuse 5 und damit in die zweite Atmosphäre eingebracht werden müssen. Ebenso gut kann das Verfahren auch ohne den Zusatz von Precursoren mit einem reinen Prozessgas 7 durchgeführt werden, um eine Plasmabehandlung des Werkstückes 3 auf seiner "Rückseite" durchzuführen.

In der in Fig. 1 dargestellten Anordnung wird gezielt und selektiv nur eine Seite des Werkstückes plasmabehandelt bzw. plasmabeschichtet und die andere Seite bleibt unbehandelt bzw. unbeschichtet. Dies ist insbesondere wichtig, da z.B. bei Polymerfolien als Werkstück 3 für viele Veredelungsprozesse, wie z.B. das Siegeln in der Verpackungsindustrie, unbehandelte Polymeroberflächen eine unabdingbare Voraussetzung sind.

In Fig. 1 ist dargestellt, dass die beiden Barrierenelektroden 1, die zusammen ein Hochspannungselektrodenpaar bilden, durch einen Spalt voneinander getrennt und beabstandet sind. Wichtig ist hier anzumerken, dass - solange dieser Spalt bzw. Abstand zwischen den Barrierenelektroden 1 nicht zu groß wird, auf der Rückseite des Werkstückes 3 immer noch eine durchgehende und kontinuierliche Plasmaentladung 4 ausgebildet wird. Die Einstellung des in Fig. 1 gezeigten Spaltes wird der Fachmann anhand seines Fachwissens oder anhand von einfachen Versuchsreihen vornehmen.

Die in Fig. 1 gezeigte Anordnung der Barrierenelektroden ist nicht beschränkend. Ebenso gut können auf jeder Seite des dort gezeigten Spaltes mehrere Barrierenelektroden 1 ohne Belassung eines weiteren Spaltes und unmittelbar aneinandergereiht werden. Auch ist es möglich, mehr als zwei durch Spalte voneinander getrennte Barrierenelektroden 1 als Elektrodenanordnung vorzusehen.

Als Prozessgas 7 eignen sich z.B. Luft, Stickstoff, Kohlendioxid, Wasserstoff oder Edelgase wie etwa Argon, oder Gemische aus diesen Gasen. Geeignete Precursoren 6 sind z.B. Tetramethylorthosilikat, Hexamethylendisiloxan in der Gasphase oder auch gasförmige Precursoren wie z.B. Silan. Mit diesen Precursoren kann z.B. eine Siliziumdioxidschicht im Bereich von wenigen Nanometern bis Mikrometern auf der "rückseitigen" Oberfläche des Werkstückes abgeschieden werden. Eine solche Schicht stellt in ihrer Funktion eine Substitution eines nasschemischen Primers dar. Je nach Art der Precursoren können aber auch andere Schichtarten mit anderen chemischen Funktionen und auch anderen Wirkungen als Antihaft-, Antikratz- oder auch Barrierenschicht abgeschieden werden.

Die im Ausführungsbeispiel gezeigten Barrierenelektroden 1 können eine Länge von bis zu mehreren Metern aufweisen. Die zum Aufbau einer Spannungsdifferenz zwischen den Barrierenelektroden 1 im Verlaufe der Hochspannung (Wechselspannung) mit unterschiedlichem Potential zu versehenden Leiter 2 können beispielsweise eine Metallpulverfüllung oder aber auch eine Metallbeschichtung der Barrierenelektroden 1 von innen sein. Bevorzugt werden als Barrierenelektroden 1 solche aus Rechteckrohren mit je einem oder aber mehreren Kanälen gewählt.

In diesem Ausführungsbeispiel wird für die Ausführung des erfindungsgemäßen Verfahrens bevorzugt eine Sinusspannung zwischen 10 bis 60 Kilovolt mit einer Frequenz von 1 bis 100 Kilohertz, vorzugsweise 5 bis 30 Kilohertz verwendet. Die Spannung kann dabei auch gepulst sein.

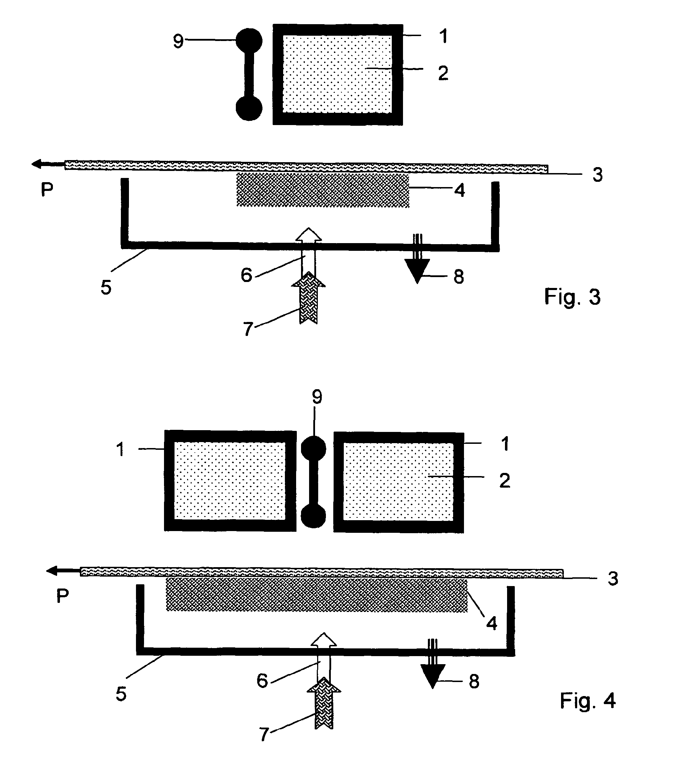

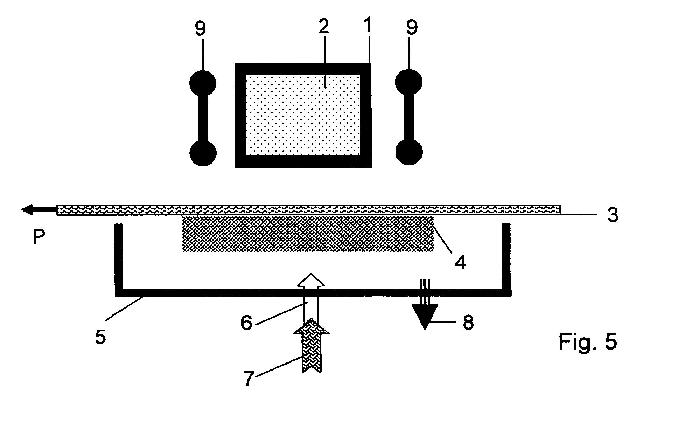

In den Figuren 2 bis 5, in denen ansonsten eine gleichartige Entladungssituation gezeigt ist, sind für die Verwendung mit dem erfindungsgemäßen Verfahren geeignete, unterschiedliche Elektrodenanordnungen dargestellt, ohne dass diese eine abschließende Darstellung bilden. In Fig. 2 ist eine ähnliche Anordnung wie in Fig. 1 dargestellt, wobei die dort gezeigten Hochspannungselektroden Metallelektroden 9 sind. In den weiteren Figuren 3 bis 5 sind unterschiedliche Elektrodenanordnungen aus Barrierenelektroden 1 und Metallelektroden 9 dargestellt, die sich ebenfalls für die Durchführung des erfindungsgemäßen Verfahrens eignen.

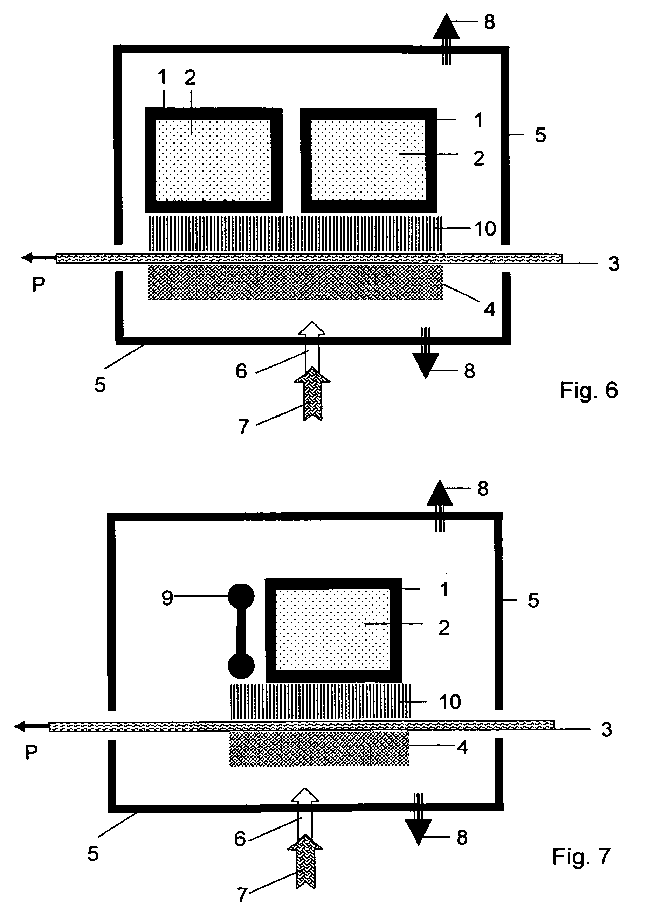

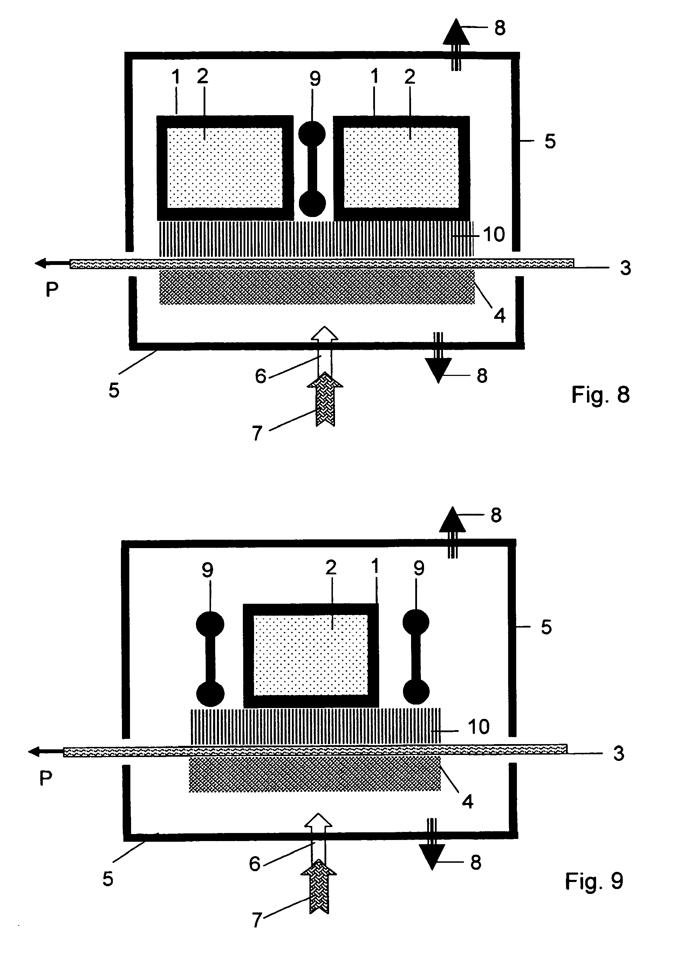

In den Figuren 6 bis 9 ist - ebenfalls in unterschiedlicher Bestückung der Elektrodenanordnung mit Barrierenelektroden 1 und Metallelektroden 9 - eine Vorrichtung zur Durchführung des erfindungsgemäßen Verfahrens in einer zweiten Variante dargestellt.

Ausführlich beschrieben werden soll dieses Verfahren und seine Arbeitsweise unter Bezugnahme auf Fig. 6. Mit Vorrichtungen mit andersartig zusammengesetzten Elektrodenanordnungen arbeitet dieses Verfahren gleichermaßen, so dass sich eine weitere Beschreibung hier erübrigt.

In dem in den Figuren 6 bis 9 gezeigten Fall ist sowohl auf der "Rückseite" des Werkstückes als auch auf der der Elektrodenanordnung zugewandten "Vorderseite" ein Gehäuse 5 angeordnet, welches jeweils einen Raum (auf der "Vorderseite" einen ersten Raum und auf der "Rückseite" einen zweiten Raum) umschließt. Der zweite Raum wird wie im Zusammenhang mit den Figuren 1 bis 5 dargestellt und beschrieben mit einem Prozessgas 7 und ggf. zugesetzten Precursoren 6 beschickt und ist an eine Absaugung 8 angeschlossen. Dadurch zündet auch in dieser Verfahrensvariante auf der "Rückseite" des Werkstückes 3 gezielt eine Plasmaentladung 4.

Anders als in dem oben beschriebenen Ausführungsbeispiel ist in diesem Ausführungsbeispiel die Atmosphäre in dem ersten Raum (den in einem Gehäuse 5 umschlossenen Raum, welcher die Elektrodenanordnung enthält) in Abstimmung mit der angelegten Hochspannung so gewählt, dass auch hier eine Plasmaentladung 10 zündet. Hier kann (in den Figuren nicht gezeigt) diesem Raum ebenfalls ein Prozessgas zugegeben werden, welches sich in seiner Zusammensetzung von dem Prozessgas 7, welches von dem in den von dem Gehäuse 5 umschlossenen Raum auf der "Rückseite" des Werkstückes 3 eingespeisten Prozessgas 7 unterscheidet. Auch der von dem Gehäuse 5 auf der die Elektrodenanordnung enthaltenden Seite des Werkstückes 3 umschlossene Raum ist an eine Absaugung 8 angeschlossen, um auch hier durch die Plasmaentladung 10 entstandene Reaktionsprodukte, wie insbesondere Ozon, abzusaugen und unschädlich zu machen.

Entscheidend ist, dass in dem hier gezeigten Ausführungsbeispiel eine Einspeisung von Precursoren lediglich auf der "Rückseite" des Werkstückes vorgesehen ist, Precursoren werden in die Plasmaentladung 10 auf der Elektrodenseite nicht eingebracht, um eine Beschichtung der Hochspannungselektroden (Barrierenelektroden 1 / Metallelektroden 9) zu vermeiden.

In der hier gezeigten zweiten Variante ermöglicht das erfindungsgemäße Verfahren eine Plasmabehandlung und/oder Plasmabeschichtung auf der "Rückseite" des Werkstückes 3 und zugleich eine Plasmabehandlung auf dessen Elektrodenanordnung zugewandten "Vorderseite".

Die dargestellten und beschriebenen Ausführungsbeispiele beschränken den Umfang der beanspruchten Erfindung nicht und dienen lediglich der weitergehenden Erläuterung derselben.

### Bezugszeichenliste

- 1: Barrierenelektrode
- 2: elektrischer Leiter
- 3: Werkstück
- 4: Plasmaentladung
- 5: Gehäuse
- 6: Precursor
- 7: Prozessgas
- 8: Absaugung
- 9: Metallelektrode
- 10: Plasmaentladung (Elektrodenseite)

- P: Pfeil (Bewegungsrichtung)

## Patentansprüche

1. Verfahren zur kontinuierlichen Atmosphärendruck Plasmabehandlung und/oder Plasmabeschichtung von elektrisch isolierenden Werkstücken, insbesondere Materialplatten oder -bahnen, wobei ein zu behandelndes Werkstück in einem Abstand unterhalb wenigstens einer sich quer zu der Bewegungsrichtung zumindest über die Breite der zu behandelnden Oberfläche des Werkstückes erstreckenden Hochspannungselektrode angeordnet und die Elektrode und das Werkstück in einer Bewegungsrichtung relativ zueinander in Bewegung versetzt werden, wobei an die Hochspannungselektrode eine Hochspannung, vorzugsweise in Form einer Wechselspannung, angelegt wird, **dadurch gekennzeichnet, dass** ein erster zwischen der Hochspannungselektrode und dem Werkstück gelegener Raum mit einer ersten Atmosphäre und dass ein zweiter auf der der Hochspannungselektrode abgewandten Seite des Werkstückes gelegener, an eine Rückseite desselben angrenzender Raum mit einer zweiten von der ersten Atmosphäre verschiedenen Atmosphäre gefüllt wird, wobei die Wahl der Hochspannung sowie der ersten und der zweiten Atmosphäre derart erfolgt, dass eine Plasmaentladung in der zweiten Atmosphäre zündet.

2. Verfahren nach Anspruch 1, **dadurch gekennzeichnet, dass** die erste und die zweite Atmosphäre durch unterschiedliche Gase oder Gasgemische gebildet werden.

3. Verfahren nach einem der vorhergehenden Ansprüche, **dadurch gekennzeichnet, dass** die erste und die zweite Atmosphäre auf unterschiedlichen Drücken gehalten werden.

4. Verfahren nach einem der vorhergehenden Ansprüche, **dadurch gekennzeichnet, dass** die Wahl der Hochspannung sowie der ersten und der zweiten Atmosphäre derart erfolgt, dass eine Plasmaentladung ausschließlich in der zweiten Atmosphäre zündet.

5. Verfahren nach einem der vorhergehenden Ansprüche, **dadurch gekennzeichnet, dass** in die zweite Atmosphäre chemische Reagenzien (Precursoren) als Ausgangsmaterialien für eine Plasmabeschichtung auf der der Hochspannungselektrode abgewandten Seite des Werkstückes eingebracht werden.

6. Verfahren nach einem der vorhergehenden Ansprüche, **dadurch gekennzeichnet, dass** ein Paar aus wenigstens zwei auf derselben Seite des Werkstückes angeordneten Hochspannungselektroden für die Erzeugung der Plasmaentladung (Koronaentladung) eingesetzt werden.

7. Verfahren nach einem der vorhergehenden Ansprüche, **gekennzeichnet durch** wenigstens eine Barrierenelektrode als Bestandteil der wenigstens einen Hochspannungselektrode.

8. Verfahren nach einem der vorhergehenden Ansprüche, **gekennzeichnet, durch** wenigstens eine Metallelektrode als Bestandteil der wenigstens einen Hochspannungselektrode.

## Claims

1. A method of continuous plasma treatment and/or plasma coating under atmospheric pressure for electrically insulating parts, in particular material plates or strips, wherein a part to be treated is arranged at a distance beneath at least one high voltage electrode extending perpendicular to the feed direction at least across the width of the surface of the part to be treated and the electrode and the part are offset relative to one another in a feed direction, wherein high voltage, preferably in the form of a alternate voltage, is applied to the high voltage electrode, **characterised in that** a space provided between the high voltage electrode and the part is filled with a first atmosphere and that a second space adjoining the back of the former space, arranged on the side of the part opposite to the high voltage electrode, is filled with a second atmosphere, different from the first atmosphere, wherein the high voltage as well as the first atmosphere and the second atmosphere are selected to cause a plasma discharge in the second atmosphere.

2. A method according to claim 1, **characterised in that** the first atmosphere and the second atmosphere are composed of different gases or gas mixtures.

3. A method according to any of the preceding claims, **characterised in that** the first atmosphere and the second atmosphere are maintained at different pressures.

4. A method according to any of the preceding claims, **characterised in that** the high voltage as well as the first atmosphere and the second atmosphere are selected to cause a plasma discharge exclusively in the second atmosphere.

5. A method according to any of the preceding claims, **characterised in that** chemical reactants (precursors) as starting materials for plasma coating on the side of the part opposite to the high voltage electrode are introduced in the second atmosphere.

6. A method according to any of the preceding claims, **characterised in that** a pair of at least two high voltage electrodes arranged on the same side of the part are installed for generating the plasma discharge (corona discharge).

7. A method according to any of the preceding claims, **characterised by** at least one barrier electrode as component of said at least one high voltage electrode.

8. A method according to any of the preceding claims, **characterised by** at least one metal electrode as component of said at least one high voltage electrode.

## Revendications

1. Procédé de traitement plasma et/ou enduction plasma à la pression atmosphérique continue pour pièces isolantes, en particulier des plaques ou des bandes de matériau, dans lequel une pièce à traiter est située à une distance donnée sous au moins une électrode haute tension disposée perpendiculairement au sens de déplacement au moins sur la largeur de la surface à traiter de la pièce d'usinage et l'électrode et la pièce sont décalées l'une par rapport à l'autre en mouvement dans un sens de déplacement donné, dans lequel une haute tension, de préférence sous forme de tension alternative, est appliquée à l'électrode haute tension, **caractérisé en ce qu'**un premier espace aménagé entre l'électrode haute tension et la pièce est remplie d'une première atmosphère et qu'un second espace limitrophe du dos de la pièce, aménagé sur le côté de la pièce opposé à l'électrode haute tension, est rempli d'une seconde atmosphère, différente de la première, dans lequel le choix de la haute tension de même que de la première atmosphère et de la seconde atmosphère a pour but de provoquer une décharge plasma dans la seconde atmosphère.

2. Procédé selon la revendication 1, **caractérisé en ce que** la première atmosphère et la seconde atmosphères sont constituées de gaz ou de mélanges gazeux différents.

3. Procédé selon l'une quelconque des revendications précédentes, **caractérisé en ce que** la première atmosphère et la seconde atmosphère sont maintenues à des pressions différentes.

4. Procédé selon l'une quelconque des revendications précédentes, **caractérisé en ce que** le choix de la haute tension de même que de la première atmosphère et de la seconde atmosphère a pour but de provoquer une décharge plasma exclusivement dans la seconde atmosphère.

5. Procédé selon l'une quelconque des revendications précédentes, **caractérisé en ce que** l'on introduit dans la seconde atmosphère des réactifs chimiques (précurseurs) comme matériaux de départ pour réaliser une enduction plasma sur le côté de la pièce opposé à l'électrode haute tension.

6. Procédé selon l'une quelconque des revendications précédentes, **caractérisé en ce que** l'on installe une paire composée d'au moins deux électrodes haute tension disposées sur le même côté de la pièce pour provoquer la décharge plasma (décharge corona).

7. Procédé selon l'une quelconque des revendications précédentes, **caractérisé par** au moins une électrode barrière comme composante de ladite au moins une électrode haute tension.

8. Procédé selon l'une quelconque des revendications précédentes, **caractérisé par** au moins une électrode en métal comme composante de ladite au moins une électrode haute tension.
